# EUROPEAN PATENT APPLICATION

(11) **EP 4 560 301 A1**
(43) Date of publication of application: **28.05.2025**
(21) Application number: 24306920.0
(22) Date of filing: 18.11.2024
(51) Int. Cl.: G01N 27/04

(54) **CABLE PEELING ENCAPSULATION SYSTEM**

(30) Priority: 23.11.2023 NO 20231276
(71) Applicant: Nexans, 92400 Courbevoie (FR)
(72) Inventor: DOEDENS, Espen, 92400 COURBEVOIE (FR); JARVID, Erik Markus, 92400 COURBEVOIE (FR)
(74) Representative: Onsagers AS

(57) **Abstract**

The present invention relates to a test setup comprising a first planar electrode, a second planar electrode, and layers of a sample of an electric cable. The present invention further relates to a test fixture comprising the test setup. The present invention also relates to a method of analyzing an electrical property of a sample of an electrical cable using the test fixture.

## Description

### FIELD OF THE INVENTION

The present invention relates to a test setup for analyzing the materials of high voltage cables which test setup comprises a first planar electrode, a second planar electrode, and layers of a sample of the cable. The present invention further relates to a test fixture comprising the test setup. The present invention also relates to a method of analyzing an electrical property of a sample of an electrical cable using the test fixture.

### BACKGROUND

High-voltage cables have become increasingly significant in electric power transmission systems. Such cables operate at voltages of greater than 60 kV and up to 1,000 kV or even more either as direct current (DC) cables or alternating current (AC) cables.

High voltage cables typically comprise a central electrical conductor, mostly aluminum or copper, and successively and coaxially around this electrical conductor, a semiconductive inner layer, an electrically insulating intermediate layer, a semiconducting outer layer. These layers are based on polymer(s), which can be crosslinked or not.

In particular, high-voltage direct current (HVDC) electric power transmission systems have become increasingly significant in the global energy transition as these systems enable intercontinental energy connections which could help to deal with the fluctuations of wind power and photovoltaics.

In order to profit from the advantages associated with HVDC electric power transmission systems, it requires that the voltage of the transmitted current is increased to high levels. Today these systems are construed to transmit power in voltage regimes of more than 1.000 kV, which requires research and development on materials to deliver properties of materials promising to fulfil the needs when operating in such high voltage regimes.

A key factor for HVDC cables concerns the insulating material surrounding the metal conductor in the center of the cable. The preparation of the samples to be analyzed is time consuming and elaborate. Further, the methods for analyzing the key properties of the materials do not fulfil all needs. The conductivity and the space charge belong to the key properties of the insulating material. The methods for analyzing these properties have turned out to be less reliable, especially in cases where high voltages are to be applied in the measurement of electrical conductivity or space charge.

The invention's underlying problem relates to the provision of a setup which enables a reliable measurement of the electrical properties, in particular a reliable measurement of the electrical conductivity and a reliable measurement of the space charge.

### SUMMARY OF THE INVENTION

The invention's underlying problems are solved by the subject-matter of claim 1. A first aspect of the invention therefore relates to a test setup comprising a first planar electrode, a second planar electrode, and layers of a sample of an electric cable, wherein at least one layer of the sample is arranged between the first planar electrode and the second planar electrode, as inner layer(s), to form a stack, wherein said stack is sandwiched between layers of the sample as outer layers of the sample.

The layers to be analyzed in the test setup of the invention are layers which are obtained from a high voltage cable. The layers to be analyzed in the test setup of the invention are not to be understood as the distinguishing layers of a high voltage cable, i.e. insulating layer, semiconductive layer etc. The layers of the sample may be obtained from a destructive disassembly of the high voltage cable as e.g. a peeling step performed before assembling the test setup. The destructive disassembly of the high voltage cable results in obtaining the sample. According to the invention, this obtained sample is provided three-fold as layers of the sample. The layers distinguish from one another by their arrangement relative to the electrodes: There is at least one layer arranged between the first planar electrode and the second planar electrode. Since this at least one layer is arranged between said electrodes, the layer(s) is (are) designated as inner layer(s). The layers arranged to between said electrodes are designated as outer layers. The outer layers are designated as outer layers since they are not between said electrodes. There is at least one layer attached to the first electrode, but on the opposite side to the at least one inner layer relative to the first electrode, and at least one layer attached to the second electrode, but on the opposite side to the at least one inner layer relative to the second electrode.

State of the art analysis of electrical properties of samples of an electric cable are typically performed in that the sample to be analyzed is arranged between two planar electrodes, an electrical field is applied by the two planar electrodes, and an electrical quantity is measured. The arrangement of the sample sandwiched between two planar electrodes and - where applicable - further elements form a stack.

According to the invention, the stack of at least one layer of the sample, the first planar electrode and the second planar electrode is again sandwiched between further layers of the sample. These further layers of the sample are the outer layers of the sample.

Those layers of the sample sandwiching the stack are designated as outer layers. There is at least one outer layer in contact with the first planar electrode and at least one outer layer in contact with the second planar electrode. In total, the test setup comprises at least two outer layers. The term "outer layers" does not necessarily mean that the outer layers are outermost layers. The term is understood such that the outer layers sandwich the stack comprising the first planar electrode, the second planar electrode and at least one layer of the peeling sample as an inner layer or more than one layer of the peeling sample as inner layers. In the latter case, the more than one layer of the peeling sample is arranged between the first planar electrode and the second planar electrode. There is thus at least one layer of the sample as an outer layer attached to the first planar electrode and at least one layer of the sample as an outer layer attached to the second planar electrode.

At least the sample layer between the planar electrodes, the planar electrodes and the outer layers of the sample form the test setup. The test setup according to the invention is associated with two advantages. Firstly, the outer layers compress the stack and thus the sample layer(s) between the planar electrodes are encompassed by the outer layers. The stack with the outer layers of the sample serves as a reservoir of the chemical species and the setup limits the impact in case small amounts escape the enclosure of the test cell. The chemical species diffuse in and out of the volume where the electrical property is actually measured, but the diffusion in and out takes place approximately at an equal rate. By this setup, the properties of the sample are thus measured as the sample is, i.e. with all its constituents. Secondly, the electric field exerted by the two planar electrodes is distributed homogeneously throughout the sample material. The reason for that is the electric field exerted by the two planar electrodes is not solely existent between the planar electrodes only. The electric field is present beyond the space between the planar electrodes. The examples below will show the electric field near the planar electrodes. These two advantages result in more reliable measurements of electrical properties. Shortly, it ensures electrodes are being squeezed in between good high voltage materials, i.e. those providing good electrical properties, defect free, and it ensures that chemical composition and cross-contamination (e.g. diffusion of chemicals, humidity, etc.) between measurement sample and material above and below it is controlled.

The test setup with the property of electrodes being enclosed by the sample to be analyzed enable an improved distribution of the electrical field throughout the sample. It was figured out that the improved field distribution enables conductivity measurements with the application of a voltage of up to 30 kV/mm, which is much higher than in conventional experiments.

The term "sample" is understood as a part of the cable to be analyzed. The sample is preferably a part of an extruded HVDC cable. The sample is more preferred a part of the insulating system of an extruded HVDC cable.

In one aspect, the sample of an electric cable is selected from the group consisting of a press molded plate sample of an electric cable, an extruded tape sample of an electric cable and a peeling sample of an electric cable, preferably the sample of an electric cable is a peeling sample of an electric cable, more preferred the sample is a peeling sample of an extruded HVDC cable.

In one aspect, the test setup further comprises a guard ring being connected to ground potential which guard ring being an electrical conductor surrounding in plane the second planar electrode, wherein the guard ring has no electrical contact to the second planar electrode, wherein the guard ring and the second planar electrode are arranged between the at least one inner layer of the sample and at least one outer layer of the sample. The guard ring is necessarily arranged on the ground side and not on the high voltage side. In the framework of this application, the electrode on the ground side is designated as second planar electrode.

The guard ring enables a more reliable measurement of electrical properties by cutting off creeping current. The electrical conductivity is measured by applying a potential difference between the first planar electrode and the second planar electrode. In doing so, the electrical current may flow on the surface of the sample instead of solely flowing through the sample wherein only the latter enables the measurement of the electrical conductivity. The current flowing on the surface of the sample is discharged by the guard ring and does therefore not account for the measurement of the electrical conductivity.

The ring does not necessarily be a circular ring. For the function of the guard ring, it must be an element surrounding the second planar electrode such that current not flowing through the sample does not account for the measurement.

In one aspect, the first planar electrode, the second planar electrode and the layers of the sample each comprise a rim, wherein the rim of the first planar electrode and rim of the second planar electrode are within the rim of the layers of the sample when viewed in projection perpendicular to the plane of the layers of the sample.

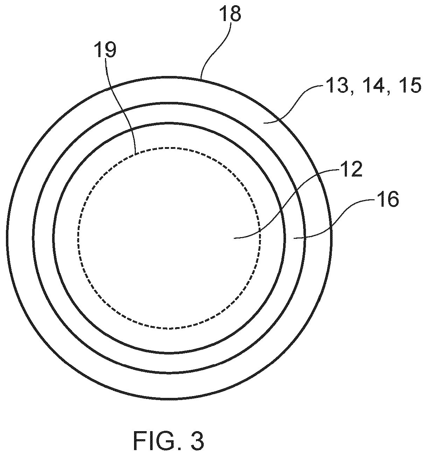

Both the planar electrodes and the layers of the sample have their margins, i.e. rims. If the layers and the planar electrodes are each viewed from the perspective perpendicular to the plane of the layers respectively the electrodes, so if the projection is viewed, their outer points with the largest distance from the center form their rims. According to the above aspect, the projection of the layers of the sample covers the projection of the first and second planar electrode. This enables the electrodes to be fully surrounded by the material of the sample. The beneficial effect associated with this arrangement refers firstly to an improved uniform distribution of the electrical field between the first and the second planar electrode and secondly to an inhibition of migration of chemical species out of the electrical field between the first and the second planar electrode. Figure 3 shows the layers, the guard ring and one of the electrode from the perspective perpendicular to the plane of the layers.

In one aspect, all layers have the same dimension. In that case, in the perspective perpendicular to the plane, there is only one rim visible because the rim of the layers are all the same.

In one aspect, the first planar electrode and the second planar electrode are congruent. The term "congruent" is to be understood in its mathematical meaning. It basically means that the first planar electrode and the second planar electrode are identical. The electrodes are designated as "first" planar electrode and "second" planar electrode. One electrode serves as high voltage electrode the other electrode is the ground electrode.

The first planar electrode and the second planar electrode should be as thin as possible; they are thus thin metal films or thin substrates subjected to a metal coating. For instance, first planar electrode and the second planar electrode can be made of a substrate subjected to vacuum deposition or sputter coating of a metal or semiconductive material. Alternatively, they are made of a semiconductive material disk. They should be as thin as possible in order not to bend the layers of the sample, which would cause inhomogeneities of the electrical field between the electrodes.

In one aspect, the outer layer of the sample attached to the first planar electrode comprises at least one through-hole, and the outer layer attached to the second planar electrode comprises at least two through-holes, preferably at least three through-holes.

The through-holes serve for the electrical connection to the planar electrodes and the guard ring. In order to connect the first electrode to high potential, there is foreseen one through-hole in the outer layer(s) attached to the first planar electrode. In order to connect the guard ring and the second electrode to an electric circle, it requires at least one through-hole for each connection. For the connection to the guard ring, it is preferred to have at least two, even more preferred three through-holes.

In one aspect, the guard ring is connected to two wires. For this purpose, the outer layer attached to the second planar electrode is provided with three through-holes. With connecting two wires to the guard ring, a conductivity test can be performed in order to verify that electrical connection to ground potential is set in place.

In one aspect, the layers of the sample have a circular shape, and/or wherein the planar electrodes have a circular shape. The shape is regarded in view perpendicular to the plane of the layers respectively the planar electrodes. The circular shape serves for avoiding an electric field enhancement at the corners, and to obtain an easily defined test area. Further, the setup of the invention enables a reduction of loss of volatile chemical species. The circular shape promotes the effect of reducing the loss of volatile chemical species, if it is not totally avoided.

The invention's underlying problems are further solved by the subject-matter of claim 9. A second aspect of the invention therefore relates to a test fixture comprising the test setup according to a first aspect of the invention and further comprising two jaws, wherein the two jaws are mechanically connected to one another.

The two jaws enable the fixture of the test setup and may provide the possibility of an electrical connection by using plugs put into sockets which may be foreseen in the two jaws. In order to fix the test setup, the two jaws are mechanically connected to one another. Since the electrodes are enclosed in the sample, the whole test setup is part of the subject-matter designated as test fixture. The test fixture is built of the test setup with the gadget to fix the test setup and to enable the connection to electrical circuits. The test fixture can alternatively designated as analysis fixture setup.

In one aspect, the two jaws exert a compression force to the test setup. The compression force causes a pressure to the test setup. This enables that the sample material is fully surrounded by the sample.

In one aspect, the test fixture further comprises springs connecting the two jaws which exert the compression force to the test setup. The springs represent the technically easiest way of exerting the compression force to the test setup.

In one aspect, the two yaws comprise through-holes communicating with the through-holes of the outer layers of the sample. The through-holes in the yaws provide the possibility of connecting the wires led through the through-holes of the test setup to an outside part of the test fixture.

The invention's underlying problems are further solved by the subject-matter of claim 13. A third aspect of the invention therefore relates to a method of analyzing an electrical property of a sample of an electrical cable, wherein the method comprises the steps of
- providing layers of the sample of the electrical cable;
- making a stack of at least one layer of the sample with the first planar electrode on one side of the at least one layer of the sample and the second planar electrode and the guard ring on the other side of the at least one layer of the sample;
- arranging a first outer layer of the sample to the first planar electrode and arranging a second outer layer of the sample on the second planar electrode and the guard ring to obtain the test setup;
- arranging the test setup between two jaws, the two jaws being mechanically connected to one another;
- providing an electrical connection to the first planar electrode, an electrical connection to the second planar electrode, and an electrical connection to the guard ring;
- measuring the electrical property.

The method according to the invention enables a reliable measurement of electrical properties. The setup foresees the enclosing of electrodes by the sample to be analyzed. The electrical field is distributed throughout the sample. It was figured out that the improved field distribution enables conductivity measurements applying a voltage of 30 kV/mm.

In one aspect, measuring the electrical property comprises measuring the electric conductivity of the sample of the electric cable, preferably of a peeling sample of the electric cable, more preferred of a peeling sample of an extruded HVDC cable.

It turned out that the measurement of the electric conductivity of peeling samples of an electric cable, in particular a peeling sample of an extruded HVDC cable, can be measured in higher accuracy and reliability if layers of the sample cover the stack on both sides.

In one aspect, measuring the electrical property comprises measuring the space charge of the sample of the electric cable, preferably of a peeling sample of the electric cable, more preferred of a peeling sample of an extruded HVDC cable.

It turned out that the measurement of the space charge of peeling samples of an electric cable, in particular a peeling sample of an extruded HVDC cable, can be measured in higher accuracy and reliability if layers of the sample cover the stack on both sides.

In one aspect, the step of providing the electrical connection to the guard ring comprises electrically connecting the guard ring to ground potential.

The connection of the guard ring to ground potential allows to exclude current circumventing the sample, e.g. by streaming on the surface of the sample, from the measurement. For an appropriate functionality, it requires that the guard ring surrounds the second electrode without having electrical contact to the second electrode.

In one aspect, the method further comprises the step of making at least one through-hole in the first outer layer of the sample and at least two through-holes in the second outer layer of the sample.

The through-hole in the first outer layer of the sample enables the electrical connection to the first electrode. The at least two through-holes enable the electrical connection to the second electrode, respectively to the guard ring.

In one aspect, the step of providing the electrical connection to the first planar electrode, the electrical connection to the second planar electrode, and the electrical connection to the guard ring comprises providing the electrical connection to the first planar electrode via a wire laid through the through-hole of the first outer layer, providing the electrical connection to the second planar electrode via a wire laid through the through-hole of the second outer layer, and providing the electrical connection to the guard ring via a wire laid through the through-hole of the second outer layer.

The setup enables the electrical connection to the electrodes respectively the guard ring. In practice, the wires as for the wires, small spring-loaded contact probes are used for the electrical connection.

In one aspect, the method further comprises the step of making at least three through-holes in the second outer layer of the sample.

One through-hole is used for electrical connection to the electrode. Two through-holes are used for connecting two wires to the guard ring. This enables the performance of a conductivity test. An electric circuit can be tested through the two wires and the guard ring. If the circuit is closed, the guard ring is electrically connected to ground.

In one aspect, the step of providing the electrical connection to the second planar electrode and the electrical connection to the guard ring comprises providing the electrical connection to the second planar electrode via a wire laid through the first through-hole of the second outer layer, and providing two electrical connections to the guard ring via a first wire laid through the second through-hole of the second outer layer and a second wire laid through the third through-hole of the second outer layer, wherein the method comprises a step of testing the electrical conductivity through the first wire, the guard ring and the second wire.

The preferred method comprises the test whether or not the guard ring is connected to ground. The connection to ground ensures that solely the current pathing through the sample between the two electrodes encounter for the measurement of the electrical conductivity.

In one aspect, the step of providing layers of the sample of the electrical cable is performed by punching the layers of the sample of the electrical cable with a template.

The preferred method is associated with the beneficial effect that the method can be efficiently performed.

In one aspect, the method is performed by use of the test setup according to the invention. In one further aspect, the method is performed by use of the test fixture according to the invention.

Features being solely disclosed in connection with the test setup of the invention are deemed to be disclosed in connection with the test fixture of the invention and the method of the invention and vice versa.

### BRIEF DESCRIPTION OF THE DRAWINGS

Certain aspects of the presently disclosed subject-matter will be described with reference to the accompanying drawings, which are representative and schematic in nature and are not to be considered to be limiting in any respect as it relates to the scope of the subject-matter disclosed herein:
Figure 1 depicts a test setup;
Figure 2 depicts one of a pair of jaws used for the test fixture;
Figure 3 depicts a schematic view on the test setup perpendicular to the plane of the sample layers; and

### DESCRIPTION OF EMBODIMENTS

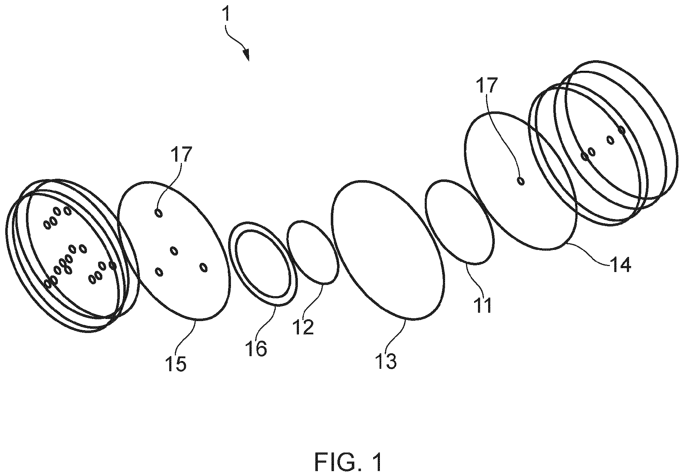

Figure 1 shows a test setup 1 comprising a sample layer 13 between a first electrode 11 and a second electrode 12 which together form the stack. Together The guard ring 16 is arranged such that it surrounds the second electrode 12 which is foreseen to be connected to ground. The sample layers 14 and 15 represent the outer layers, wherein sample layers 14 are attached to the first electrode 11 being the high voltage electrode, and the sample layers 15 are attached to the second electrode 12 being the electrode connected to ground. The outer layers 14 and 15 have through-holes 17. The through-holes in the center of the outer layers 14 and 15 are foreseen for the electrical connection of the electrodes 11 and 12. The outer layers 15 have further through-holes for connection of the guard ring.

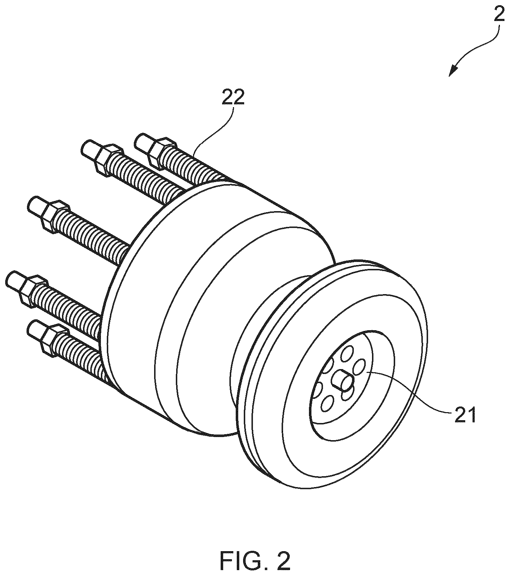

Figure 2 shows a single jaw 2 of a pair of jaws 2 holding the test setup 1. The crosspieces 22 serve for mechanically connecting two jaws 2 together such that the test setup 1 is clamped between the jaws 2. The socket 21 enable the electrical connection to the electrode 11, 12 (not shown in Fig. 2) respectively the guard ring 16 (not shown in Fig. 2).

Figure 3 shows the layers 13, 14, and 15, one of the electrodes and the guard ring from the view perpendicular to the test setup. The parts of the stack being formed by the electrode 12 and the inner layer 13 is shown. The guard ring 16 encompasses the electrode 12. In the view perpendicular to the sample layers 13, 14, and 15, these layers have the same dimension such that all three layers have the same rim 18. The rims 19 of the electrodes are fully covered by the rim 18 of the sample layers 13, 14, and 15. This setup enables the electrodes to be enclosed by sample material. It is however not required that the layers, i.e. the inner layers and the outer layers have the same dimension. In that case, there were more rims 18 visible when viewing the test setup from a view perpendicular to the test setup.

The test setup which comprises outer layers enable the measurement of electrical properties having applied up to 30 kV/mm. Without the outer layer, measurements were viable where much less than 30 kV/mm are applied.

### REFERENCE LIST

- 11: First planar electrode (high voltage side)
- 12: Second planar electrode (ground side)
- 13: Sample layer
- 14: Sample layer (outer layer attached to first electrode)
- 15: Sample layer (outer layer attached to second electrode)
- 16: Guard ring
- 17: Through-holes
- 18: Rim of sample layer
- 19: Rim of electrode
- 21: Socket
- 22: Crosspiece

## Claims

1. A test setup (1) comprising a first planar electrode (11), a second planar electrode (12), and layers (13, 14, 15) of a sample of an electric cable, wherein at least one layer (13) of the sample is arranged between the first planar electrode (11) and the second planar electrode (12), as inner layer(s) (13), to form a stack, wherein said stack is sandwiched between layers of the sample as outer layers (14, 15) of the sample.

2. The test setup (1) according to claim 1, wherein the sample of an electric cable is selected from the group consisting of a press molded plate sample, an extruded tape sample, and a peeling sample, preferably the sample is a peeling sample of an electric cable, more preferred the sample is a peeling sample of an extruded HVDC cable.

3. The test setup (1) according to claim 1 or claim 2, wherein the test setup (1) further comprises a guard ring (16) being connected to ground potential which guard ring (16) being an electrical conductor surrounding in plane the second planar electrode (12), wherein the guard ring (16) has no electrical contact to the second planar electrode (12), wherein the guard ring (16) and the second planar electrode (12) are arranged between the at least one inner layer (13) of the sample and at least one outer layer (14, 15) of the sample.

4. The test setup (1) according to any one of the preceding claims, wherein the first planar electrode (11), the second planar electrode (12) and the layers (13, 14, 15) of the sample each comprise a rim, wherein the rim (19) of the first planar electrode (11) and rim (19) of the second planar electrode (12) are within the rim (18) of the layers (13, 14, 15) of the sample when viewed in projection perpendicular to the plane of the layers (13, 14, 15) of the sample.

5. The test setup (1) according to any one of the preceding claims, wherein the first planar electrode (11) and the second planar electrode (12) are congruent.

6. The test setup (1) according to any one of the preceding claims, wherein the outer layer (14) of the sample attached to the first planar electrode (11) comprises at least one through-hole (17), and the outer layer (15) attached to the second planar electrode comprises at least two through-holes (17), preferably at least three through-holes (17).

7. The test setup (1) according to any one of the preceding claims, wherein the guard ring (16) is connected to two wires.

8. The test setup (1) according to any one of the preceding claims, wherein the layers (13, 14, 15) of the sample have a circular shape, and/or wherein the planar electrodes (11, 12) have a circular shape.

9. A test fixture comprising the test setup (1) according to any one of claims 1 to 8 and two jaws, wherein the two jaws are mechanically connected to one another.

10. The test fixture according to claim 9, wherein the two jaws exert a compression force to the test setup (1).

11. The test fixture according to claim 9 or claim 10, wherein the test fixture further comprises springs connecting the two jaws which exert the compression force to the test setup (1).

12. The test fixture according to any one of claims 9 to 11, wherein the two yaws comprise through-holes (17) communicating with the through-holes (17) of the outer layers (14, 15) of the sample.

13. A method of analysing an electrical property of a sample of an electrical cable, wherein the method comprises the steps of
• providing layers (13, 14, 15) of the sample of the electrical cable;
• making a stack of at least one layer (13) of the sample with a first planar electrode (11) on one side of the at least one layer (13) of the sample and the second planar electrode (12) and the guard ring (16) on the other side of the at least one layer (13) of the sample;
• arranging a first outer layer (14) of the sample to the first planar electrode (11) and arranging a second outer layer (15) of the sample to the second planar electrode (12) and the guard ring (16) to obtain the test setup (1);
• arranging the test setup (1) between two jaws (2), the two jaws being mechanically connected to one another;
• providing an electrical connection to the first planar electrode (11), an electrical connection to the second planar electrode (12), and an electrical connection to the guard ring (16);
• measuring the electrical property.

14. The method according to claim 13, wherein measuring the electrical property comprises measuring the electric conductivity of the sample of the electric cable, preferably of a peeling sample of the electric cable, more preferred of a peeling sample of an extruded HVDC cable.

15. The method according to claim 13, wherein measuring the electrical property comprises measuring the space charge of the sample of the electric cable, preferably of a peeling sample of the electric cable, more preferred of a peeling sample of an extruded HVDC cable.

16. The method according to any one of claims 13 to 15, wherein the step of providing the electrical connection to the guard ring (16) comprises electrically connecting the guard ring (16) to ground potential.

17. The method according to any one of claims 13 to 16, wherein the method further comprises the step of making at least one through-hole (17) in the first outer layer (14) of the sample and at least two through-holes (17) in the second outer layer (15) of the sample.

18. The method according to claim 17, wherein the step of providing the electrical connection to the first planar electrode (11), the electrical connection to the second planar electrode (12), and the electrical connection to the guard ring (16) comprises providing the electrical connection to the first planar electrode (11) via a wire laid through the through-hole (17) of the first outer layer (14), providing the electrical connection to the second planar electrode (12) via a wire laid through the through-hole (17) of the second outer layer (15), and providing the electrical connection to the guard ring (16) via a wire laid through the through-hole (17) of the second outer layer (15).

19. The method according to any one of claims 13 to 18, wherein the method further comprises the step of making at least three through-holes (17) in the second outer layer (15) of the sample.

20. The method according to claim 19, wherein the step of providing the electrical connection to the second planar electrode (12) and the electrical connection to the guard ring (16) comprises providing the electrical connection to the second planar electrode (12) via a wire laid through the first through-hole (17) of the second outer layer (15), and providing two electrical connections to the guard ring (16) via a first wire laid through the second through-hole (17) of the second outer layer (15) and a second wire laid through the third through-hole (17) of the second outer layer (15), wherein the method comprises a step of testing the electrical conductivity through the first wire, the guard ring (16) and the second wire.

21. The method according to any one of claims 13 to 20, wherein the step of providing layers (13, 14, 15) of the sample of the electrical cable is performed by punching the layers of the sample (13, 14, 15) making use of a template.

22. The method according to any one of claims 13 to 21, wherein the method is performed by use of the test setup according to any one of claims 1 to 8.
